Europäisches Patentamt

European Patent Office

Office européen des brevets

(11) Veröffentlichungsnummer: **0 433 820 A2**

## (12) EUROPÄISCHE PATENTANMELDUNG

(21) Anmeldenummer: 90123643.0

(22) Anmeldetag: 08.12.90

(51) Int. Cl.5: **G03F 1/10**, G03F 7/20, G03C 5/08

(30) Priorität: 20.12.89 AT 2896/89

(43) Veröffentlichungstag der Anmeldung:
26.06.91 Patentblatt 91/26

(84) Benannte Vertragsstaaten:
AT BE CH DE DK ES FR GB GR IT LI LU NL SE

(71) Anmelder: **RAGANITSCH GESELLSCHAFT M.B.H.**
Westbahnstrasse 27-29
A-1070 Wien(AT)

(72) Erfinder: **Raganitsch, Josef**
Hubergasse 10
A-2348 Breitenfurt(AT)

(74) Vertreter: **Puchberger, Peter, Dipl.-Ing. et al**
Patentanwälte Dipl.-Ing. Georg Puchberger
Dipl.-Ing. Rolf Puchberger Dipl.-Ing. Peter
Puchberger Singerstrasse 13
A-1010 Wien(AT)

(54) Multi-Screen-System.

(57) Die Erfindung betrifft ein Druckverfahren, dadurch gekennzeichnet, daß
- eine Bildvorlage durch einen halbtonfähigen Scanner gescannt wird,
- durch das Scannersignal ein Laserstrahl gesteuert wird, der gemäß Bildvorlage über eine lichtempfindliche Schicht geführt wird, um so ein latentes Bild der Bildvorlage herzustellen,
- wobei der Laserstrahl vor Auftreffen auf der lichtempfindlichen Schicht durch eine Diffusionsfolie geführt wird, und
- daß der so belichtete Film in bekannter Weise entwickelt und fixiert, sowie in bekannter Weise auf einen Druckträger, wie Offsetplatte, Siebdruck-Gaze etc. übertragen wird.

Fig. 2

Die Erfindung betrifft ein neues Verfahren zur Herstellung von Druckfilmen. Grundsätzlich kann dieses Verfahren bei allen Druckverfahren angewendet werden. Besonders vorteilhaft ist das Verfahren auf dem Gebiet des Kunstdruckes und überall dort, wo eine möglichst große Zahl von Farbkombinationen und hohe Auflösung gefordert sind.

Bei den heutigen Standarddruckverfahren wird überwiegend die Bildvorlage auf die eine oder andere Weise in ein Raster umgewandelt und das Raster wird gedruckt. Dadurch ist die Auflösung in Abhängigkeit von der Rasterung beschränkt und die Originale mangelhaft. Im Offsetdruck sind z.B. die verschiedenen Farben nicht beliebig mischbar. Bekanntlich weist jede Farbe eine andere Winkelung des Rasters auf. Bei Winkelungen unter 30° zueinander tritt Moirébildung auf. Dies ist akzeptabel, wenn z.B. nur vier Farben gedruckt werden. Wenn jedoch z.B. bei Kunstdrucken sogenannte Stützfarben mitgedruckt werden sollen, gibt es Schwierigkeiten bei der Winkelung.

Gemäß vorliegender Erfindung erfolgt keine geometrische Auflösung des Vorlagebildes, sondern es wird entsprechend der Vorlage eine bestimmte Rauheit auf dem Druckträger erzeugt, die die Farbe mehr oder weniger annimmt und abgibt. Eine geometrische Rasterung ist nicht vorgesehen.

Das erfindungsgemäße Druckverfahren ist in erster Linie dadurch gekennzeichnet, daß

- eine Bildvorlage durch einen halbtonfähigen Scanner gescant wird,
- durch das Scannersignal ein Laserstrahl gesteuert wird, der gemäß Bildvorlage über eine lichtempfindliche Schicht geführt wird, um so ein latentes Bild der Bildvorlage herzustellen, wobei der Laserstrahl vor Auftreffen auf der lichtempfindlichen Schicht durch eine Diffusionsfolie geführt wird, und
- daß der so belichtete Film in bekannter Weise entwickelt und fixiert, sowie in bekannter Weise auf einen Druckträger, wie Offsetplatte, Siebdruck-Gaze etc. übertragen wird.

Weitere vorteilhafte Merkmale sind den Ansprüchen und der nachfolgenden Beschreibung zu entnehmen.

Der Vorteil des erfindungsgemäßen Druckverfahrens liegt in der maximalen Originaltreue. Es kann jede beliebige Farbnuance gedruckt werden, wie z.B. auch zwanzig verschiedene Farbdrucke übereinander. Die Auflösung ist um ein Vielfaches besser als beim Offsetdruck. Die Auflösung entspricht etwa 200 - 400 Bildpunkten/cm (40.000 - 160.000 Bildinformationen/cm²). Eine Moirébildung ist nicht zu befürchten.

Im Gegensatz zu den früher bekannt gewordenen Druckverfahren wird das erzeugte Halbtonbild nicht gerastert oder in Rasterform auf den Druckträger, wie z.B. eine Offsetplatte, die Gaze einer Siebdruckmaschine etc., aufgebracht. Gemäß Erfindung wird das Halbtonbild rasterlos auf den Film gebracht, der dann auf den jeweiligen Druckträger kopiert werden kann.

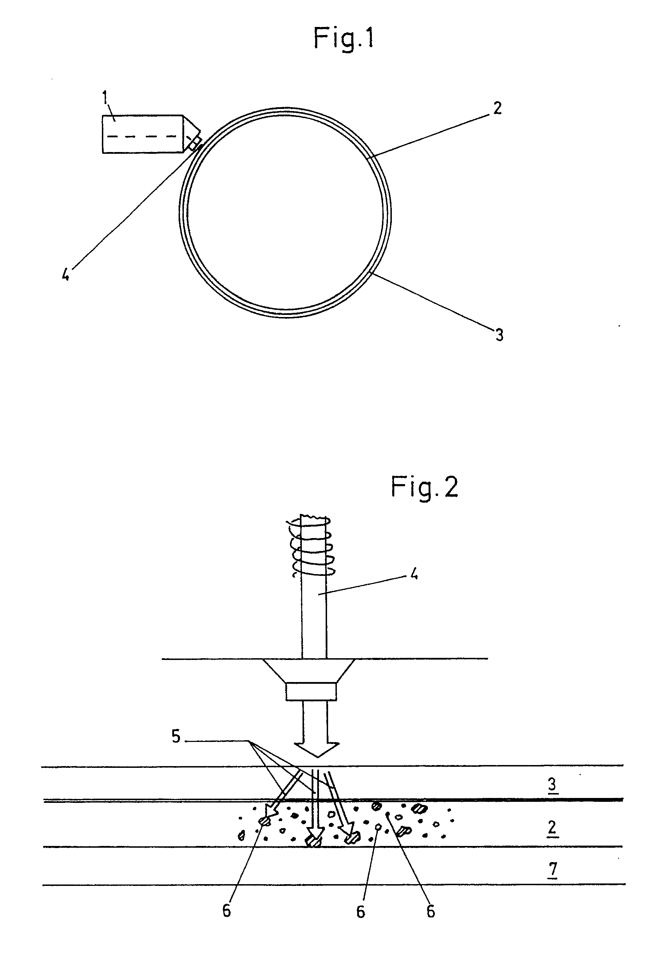

Im folgenden wird das erfindungsgemäße Verfahren beispielsweise und unter Bezugnahme auf die schematischen Figuren 1 und 2 näher beschrieben.

Das Originalbild wird in einem Scanner mit Xenonlampe abgetastet. Der Scanner muß halbtonfähig sein, das heißt er liefert Signale ohne Rasterung des Bildes. Je nach Intensität des abgetasteten Bildpunktes wird der abgenommene Strahl variiert. Bei mehrfarbigen Bildern kann der Scanner für jede gewünschte Farbe ein Bild scannen. Vier Farben sind Standard für bunte Bilder, für monochrome entsprechend weniger. Zusätzliche Farben können je nach Anforderung hergestellt werden. Derartige Scanner sind an sich bekannt.

Das vom Scanner kommende Signal wird dann gemäß Fig. 1 zum Schreiben mittels einer Laserlichtquelle 1 auf eine lichtempfindliche Schicht 2 verwendet. Der Schreibvorgang muß hochauflösend geschehen. Als Filmmaterial eignen sich besonders sogenannte Lithfilme. Es sind dies sehr hart arbeitende Filme.

Der Lithfilm wird vor dem Schreibvorgang einer sogenannten Schwellwertbelichtung ausgesetzt. Durch diese Schwellwertbelichtung kann der Film "weicher" gemacht werden. De facto wird dadurch die Empfindlichkeit angehoben.

Über den auf einer Trommel aufgewickelten Lithfilm wird eine Diffusionsfolie 3 gelegt. Wie der Fig. 2 zu entnehmen ist, wird der vom Schreibgerät kommende Laserstrahl 4 in der Diffusionsfolie 3 aufgespreizt (siehe Teilstrahlen 5), wobei jene in der Filmschicht eingelagerten Silberhalogenidkristalle 6 aktiviert werden, deren Aktivierungsbereitschaft bereits gegeben ist. Der Filmträger ist mit 7 bezeichnet.

Beim Schreibvorgang schwankt die Intensität des Laserstrahls entsprechend der Intensität der Vorlage. In der Filmschicht werden jeweils nur die reifsten Silberkristalle aktiviert. Je nach Intensität des Laserstrahls werden mehr oder weniger Kristalle aktiviert, wodurch es zu einer größeren oder kleineren Anzahl gebildeter Silberteilchen kommt. In der Folge entsteht nach Abtastung der gesamten Vorlage und Schreiben des gesamten Bildes auf den Lithfilm ein latentes Bild. Es wird durch das Entwickeln sichtbar gemacht, und das nichtbelichtete Material wird beim anschließenden Fixieren herausgewaschen.

Das sich so ergebende entwickelte Bild weist auf jeder Flächeneinheit den ihr zukommenden Grauwert auf, wobei eben keine geometrische Musterung vorgesehen ist, sondern eine unregelmäßige Verteilung der bedeckten und nicht bedeckten Teile des Films vorliegt. In herkömmlich bekannter Weise kann dann dieser Film auf den Druckträger übertragen werden, z.B. auf eine Offsetplatte oder auf Druckträger für Siebdruck oder Flexodruck.

Die Diffusionsfolie dient der Erzielung einer gleichmäßigen Auflösung. Läßt man die Diffusionsfolie fort, entsteht eine sogen. Strichzerlegung, also ein hartes Schwarz-Weiß, das nur für besondere graphische Effekte erwünscht ist.

Beispielsweise wurde für die Herstellung der Filme ein Crosfield Scanner Mod. 540 S, der für die Anforderungen auf Mod. 635 S hochgerüstet wurde, verwendet. Es eignen sich aber auch Geräte von anderen Herstellern, soferne sie die Möglichkeiten des Crosfield Scanners 635 S bieten. In diesem Scanner wird das Original abgetastet und in elektronische Impulse für die Farben Cyan, Yellow, Magenta und Black umgewandelt und zum Schreibteil geleitet, wo die vier Farbauszüge belichtet werden. Die Belichtung erfolgte bei diesem Crosfield Scanner 635 S mittels eines Argon-Laserstrahles, der durch einen Modulator in der im Abtastteil vorher analysierten Stärke variiert wurde und auf das lichtempfindliche Material auftraf. Die Schreibdichte war bei diesem Vorgang doppelt so fein wie bei einem normalen Scannvorgang und betrug 400 Linien pro cm und erfolgte noch überlappend, das heißt bei jedem Scannvorgang wurde bis zur Mitte des vorherigen Schreibvorganges nochmals darübergescannt.

Zwischen den Laserstrahl und den zu belichtenden Film wurde eine 0,10 mm starke Diffusionsfolie mit der glatten Seite zum Laserstrahl, mit der matten Seite zum Filmmaterial gelegt. Der Spreizungswinkel des in der Folie aufgespaltenen Laserstrahles betrug 18°. Es lassen sich jedoch auch gute Ergebnisse mit anderen Brechungswinkeln erzielen. Um einen optimalen Kontakt von Diffusionsfolie und dem zu belichtenden Filmmaterial herzustellen, kann die Luft herausgesaugt werden. Mit einem 80%-Vakuum läßt sich dies in der Praxis problemlos erzielen. Der lichtempfindliche Film wird vorher mit einer Schwellwertbelichtung versehen, die in einem Kontaktkopiergerät geschieht. Als Lichtquelle wurde eine Jod-Lampe mit 12 V Spannung und 50 Watt verwendet. Sensibilisiert wurde derart, daß die Spannung auf 25 % reduziert und in einem Abstand von 90 cm von Lichtquelle zu Film und 0,10 sek lang belichtet wurde. Dieser Film war so für die Weiterverarbeitung im Scanner entsprechend vorbehandelt.

Für den Schreibvorgang im Scanner eignen sich besonders Lithfilme und die darauf abgestimmte Lithentwicklung oder beispielsweise verwendete Kodak Ultratec UCS Film, der in der entsprechenden Ultratec Entwicklung zu verarbeiten ist. Es können aber auch andere Systeme, wie z.B. "Grandex" von Fuji oder "Agfastar" von Agfa verwendet werden. Die so hergestellten Filme sind kopierfähig und können dann für die jeweiligen Druckverfahren weiterverarbeitet werden. Für Siebdruck, Flexo und Buchdruck kann allerdings noch eine Vergrößerung auf die jeweilige Strukturweite notwendig sein.

Es können alle Scanner Verwendung finden, die den Anforderungen an Auflösung, Verzeichnungsfreiheit und Halbtonfähigkeit entsprechen. Es können sowohl Rundscanner als auch Flachscanner verwendet werden.

Die erfindungsgemäß hergestellten Filme können sowohl im konventionellen Buntaufbau, als auch mit UCR (Unterfarbenreduktion = under color reduction) oder mit PCR (Unbunt-aufbau nach Harald Küppers) ausgegeben werden. Bei diesen Verfahren werden auf elektronischem Weg bestimmte Farbanteile reduziert resp. in den Schwarzanteil hinübergelegt.

Für den Siebdruck weist das erfindungsgemäße Verfahren ebenfalls sehr markante Vorteile auf. Diese liegen im wesentlichen darin, daß keine Vorwinkelung am Sieb und keine Farbwinkelung der einzelnen Farbauszüge notwendig sind. Auch kann beim Bedrucken von Stoffen (z.B.Leinen, Seide etc.) keine Moireébildung durch die Stoffstruktur entstehen, da ja gemäß Erfindung ohne Raster gearbeitet wird.

Als Erweiterung im Druckbereich ist noch der "analoge elektrostatische Druck" anzuführen. Es wird dabei eine Kathodenplatte statisch aufgeladen und im Anschluß daran mit dem jeweiligen Farbauszug der gemäß Erfindung hergestellt wurde, belichtet. Die Kathodenplatte wird dann über ein Flüssigtonerbad (Y = Yellow, M = Magenta, C = Cyan und B = Black) geführt und nimmt die entsprechenden Farbpigmente auf. Der Vorgang wird jeweils für die Auszüge Y, M, C, B in gleicher Weise wiederholt. Es bildet sich dabei auf der Kathodenplatte ein 4-färbiges Bild, das im Anschluß daran auf Papier übertragen wird. Zum Schluß wird das Pigment am Papier noch thermisch fixiert. Die so erzeugten Drucke stellen eine Alternative zu dem bekannten Offsetdruck dar.

## Ansprüche

1. Druckverfahren, dadurch gekennzeichnet, daß
   - eine Bildvorlage durch einen halbtonfähigen Scanner gescannt wird,
   - durch das Scannersignal ein Laserstrahl gesteuert wird, der gemäß Bildvorlage über eine lichtempfindliche Schicht geführt wird, um so ein latentes Bild der Bildvorlage herzustellen,
   - wobei der Laserstrahl vor Auftreffen auf der lichtempfindlichen Schicht durch eine Diffusionsfolie geführt wird, und
   - daß der so belichtete Film in bekannter Weise entwickelt und fixiert, sowie in bekannter Weise auf einen Druckträger, wie Offsetplatte, Siebdruck-Gaze etc. übertragen wird.

2. Druckverfahren nach Anspruch 1, dadurch gekennzeichnet, daß die Diffusionsfolie auf der lichtempfindlichen Schicht aufliegt.

3. Druckverfahren nach Anspruch 2, dadurch gekennzeichnet, daß die Diffusionsfolie mittels Unter- oder überdruck gegen die lichtempfindliche Schicht gehalten wird.

4. Druckverfahren nach einem der vorhergehenden Ansprüche, dadurch gekennzeichnet, daß die lichtempfindliche Schicht und die Diffusionsfolie trommelförmig angeordnet sind.

5. Druckverfahren nach einem der vorhergehenden Ansprüche, dadurch gekennzeichnet, daß die lichtempfindliche Schicht vor der Belichtung durch den Laserstrahl einer Schwellwertbelichtung ausgesetzt wird, um die lichtempfindliche Schicht vorzusensibilisieren.

6. Druckverfahren nach einem der vorhergehenden Ansprüche, dadurch gekennzeichnet, daß von einer Bildvorlage für einen mehrfärbigen Druck mehrere Bilder gescannt und jedes dieser Bilder gemäß dem Verfahren nach einem der vorhergehenden Ansprüche auf einen Druckträger übertragen wird.

7. Druckverfahren nach einem der vorhergehenden Ansprüche, dadurch gekennzeichnet, daß die Diffusionsfolie für den Laserstrahl einen Spreizungswinkel von 5 bis 30°, insbesondere 18° bewirkt.

# Fig.1

# Fig.2